Europäisches Patentamt

European Patent Office

Office européen des brevets

(11) Publication number: **0 486 052 A1**

# EUROPEAN PATENT APPLICATION

(21) Application number: **91119535.2**

(22) Date of filing: **15.11.91**

(51) Int. Cl.5: **H01L 33/00**

(30) Priority: **16.11.90 JP 311931/90**

(43) Date of publication of application:
**20.05.92 Bulletin 92/21**

(84) Designated Contracting States:
**DE FR GB IT NL SE**

(71) Applicant: **DAIDO TOKUSHUKO KABUSHIKI KAISHA**
**11-18, Nishiki 1-chome**
**Naka-ku Nagoya-shi Aichi-ken(JP)**

(72) Inventor: **Kato, Toshihiro**
**7-4, Chuodai 8-chome**
**Kasugai-shi, Aichi-ken(JP)**
Inventor: **Hirotani, Masumi**
**1-6, Minamishikamochi, Kagiya-machi**
**Tokai-shi, Aichi-ken(JP)**
Inventor: **Susawa, Hiromoto**
**18, Minamishikamochi, Kagiya-machi**
**Tokai-shi, Aichi-ken(JP)**

(74) Representative: **Tiedtke, Harro, Dipl.-Ing. et al**
**Patentanwälte Tiedtke-Bühling- Kinne &**
**Partner Bavariaring 4 POB 20 24 03**
**W-8000 München 2(DE)**

(54) **Light-emitting diode for concurrently emitting lights having different wavelengths.**

(57) A light-emitting diode including a substrate and a plurality of semiconductor layers superposed on the substrate, for emitting at a time a plurality of lights having respective different wavelengths and emitted through a light-emitting surface. The above-indicated plurality of semiconductor layers includes an active layer (18) for generating a first light, upon application of an electric current thereto, and at least one photoluminescent layer (14) each for generating a light having a longer wavelength than the first light, based on the first light generated by the active layer.

FIG. 2

## BACKGROUND OF THE INVENTION

### Field of the Invention

The present invention relates to a light-emitting diode which is capable of concurrently emitting lights having different wavelengths.

### Discussion of the Prior Art

Light-emitting diodes (LED) are known as a semiconductor diode consisting of a plurality of various compound semiconductor layers which are superposed on a semiconductor substrate by epitaxy, such as vapor phase epitaxy or liquid phase epitaxy, so as to form a pn junction. It is proposed to provide the light-emitting diode with two pn junctions, for example, so that the diode can emit two kinds of lights having different wavelengths. An example of such a light-emitting diode is disclosed on page 117 of "Compound Semiconductor Device II" (published on Jan. 10, 1986 from Kogyo Chosakai Publishing Co., Ltd., Tokyo, Japan). The disclosed light-emitting diode is able to emit two kinds of lights having different wavelengths at the same time.

In fabricating the above-described diode having a plurality of pn junctions for emitting different wavelengths of lights, the number of at least the positive electrodes or at least the negative electrodes must be equal to the number of the pn junctions, for applying drive currents to the respective pn junctions. The provision of the increased number of electrodes as well as the plurality of pn junctions makes the fabricating process rather complicated, and pushes up the cost of manufacture of the diode.

## SUMMARY OF THE INVENTION

It is therefore an object of the present invention to provide a light-emitting diode which is capable of emitting two or more lights having different wavelengths at the same time, and which can be fabricated in a comparatively simple process.

The above object may be attained according to the principle of the present invention, which provides a light-emitting diode including a substrate and a plurality of semiconductor layers superposed on the substrate, for emitting at a time a plurality of lights having respective different wavelengths, the plurality of lights being emitted through a light-emitting surface, the plurality of semiconductor layers comprising: (a) an active layer for generating a first light, upon application of an electric current thereto; and (b) a plurality of photoluminescent layers each for generating a light having a longer wavelength than the first light, based on the first light generated by the active layer.

In the light-emitting diode constructed as described above, when the first light is generated by the active layer upon application of a current thereto, the photoluminescent layer utilizes the first light so as to generate the second light having a longer wavelength than the first light. Thus, the present light-emitting diode can generate a plurality of kinds of lights having different wavelengths at the same time. In this arrangement, it is not necessary to provide two or more p-n junctions and increase the number of electrodes, so as to permit the diode to generate two or more kinds of lights having different wavelengths at the same time. Therefore, the process for manufacturing the present light-emitting diode is simplified, whereby the diode is available at a relatively low cost.

## BRIEF DESCRIPTION OF THE DRAWINGS

The above and optional objects, features and advantages of the present invention will be better understood by reading the following detailed description of a presently preferred embodiment of the invention, when considered in connection with the accompanying drawings, in which:

Fig. 1 is a perspective view of one embodiment of a light-emitting diode of the present invention;

Fig. 2 is an elevational view partly in cross section of the light-emitting diode of Fig. 1; and

Fig. 3 is a graph indicating a relative spectral intensity of the light emitted by the diode of Fig. 1.

## DETAILED DESCRIPTION OF THE PREFERRED EMBODIMENT

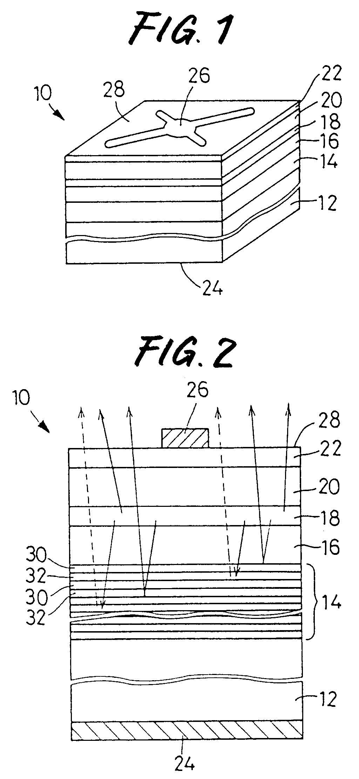

Referring to the perspective and elevational views of Figs. 1 and 2, reference numeral 10 denotes a planar or surface emission type light-emitting diode having a double-heterostructure. The surface light-emitting diode 10 has a p-GaAs single crystal substrate 12, a light-reflecting/photoluminescent layer 14 grown on the substrate 12, a p-$Ga_{0.55}Al_{0.45}As$ clad layer 16 grown on the photoluminescent layer 14, a p-$Ga_{0.87}Al_{0.13}As$ active layer 18 grown on the clad layer 16, an n-$Ga_{0.55}Al_{0.45}As$ clad layer 20 grown on the active layer 18, and an n-GaAs contact layer 22 grown on the clad layer 20. The active layer 18 is adapted to generate an electromagnetic light having a wavelength of 780nm by electroluminescence. The light-reflecting/photoluminescent layer 14, clad layer 16, active layer 18, clad layer 20 and contact layer 22 are sequentially grown each as a single crystal on the substrate 12 in the order of description, by metalorganic chemical vapor deposition (MOCVD), for example. The substrate 12 has a thickness of 350$\mu$m, and the clad layers 16, 18 have a thickness of 2$\mu$m. The active layer 18 and the contact layer 22 have a thickness of 0.1$\mu$m. The light-emitting diode 10 has a square shape in plane view having a top or bottom surface area of 350$\mu$m x 350$\mu$m. On the surface of the p-semiconductor substrate 12 remote from the light-reflecting/photoluminescent layer 14, there is formed an n-AuGe/Ni/Au ohmic electrode 24. The contact layer 22 has a light-emitting surface 28 on which is formed a p-AuZn/Ti/Au ohmic electrode 26.

The light-reflecting/photoluminescent layer 14 consists of a superlattice consisting of twenty films 30 of p-AlAs each having a thickness of 65$\mu$m, and twenty films 32 of p-GaAs each having a thickness of 54$\mu$m. The p-AlAs films 30 and the p-GaAs films 32 are alternately superposed on each other to form the superlattice 14, which serves as a wave interference type light reflector capable of reflecting a component of the light generated by the active layer 18. The layer 14 is also adapted to absorb a component of the incident light generated by the active layer 18, and generate a light having a wavelength of 870nm, which is longer than the wavelength (780nm) of the electromagnetic light generated by the active layer 18. The light-reflecting/photoluminescent layer 14 has p-GaAs films 32 whose energy gap is smaller than that of the active layer 18, which is represented by the energy of the light generated by the active layer 18. In the instant embodiment, the p-GaAs films 32 in the light-reflecting/photoluminescent layer 14 also serve as a photoluminescent layer for generating a second light (having a wavelength of 870nm), based on a first light (having a wavelength of 780nm) which is generated by the active layer 18. It is to be noted that the thickness of the light-reflecting/photoluminescent layer 14, clad layers 16, 20, active layer 18 and contact layer 22 as illustrated in Figs. 1 and 2 do not accurately represent the actual thickness of these layers 14, 16, 18, 20, 22.

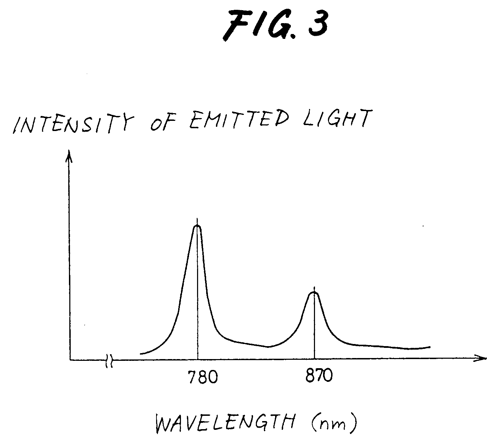

In operation of the present light-emitting diode 10 constructed as described above, a drive current is applied between the ohmic electrodes 26, 28 in the forward direction, whereby the electromagnetic light having the wavelength of 780nm is generated by the active layer 18. A component of the light generated by the active layer 18 is incident upon the contact layer 28 having the light-emitting surface 28, and the incident component is emitted from the light-emitting surface 22, externally of the diode 10, as indicated in solid lines in Fig. 2. At the same time, a component of the generated light is directed toward the substrate 12 and is incident upon the light-reflecting/photoluminescent layer 14. A portion of the incident component is reflected by the layer 14 toward the active layer 18, transmitted through the layer 18, and finally emitted through the light-emitting surface 28, as indicated in solid lines in Fig. 2. Another portion of the incident component from the active layer 18 is absorbed by the photoluminescent layer 14, whereby the light having the wavelength of 870nm is generated by the layer 14, transmitted through the active layer 18, and finally emitted through the light-emitting surface 28, as indicated in the broken lines in Fig. 2. In this manner, two kinds of lights having different wavelengths are emitted at a time from the light-emitting surface 28 of the diode 10. The graph of Fig. 3 indicates a relative spectral intensity of the light emitted by the present light-emitting diode 10. The thus constructed light-emitting diode 10 is used for optical multiplex communication, or used as a light source for a photosensor, for example.

In the instant embodiment, the 780nm-wavelength light and the 870nm-wavelength light are respectively generated by the active layer 18 and the light-reflecting/photoluminescent layer 14, only by applying a drive current between one pair of the ohmic electrodes 24, 26. Thus, the present light-emitting diode 10 is capable of emitting two lights having different wavelengths at the same time, by using only one pair of electrodes 24, 26. In this arrangement, it is not necessary to provide two active layers and increase the number of electrodes, so as to permit the diode to concurrently generate two lights of different wavelengths, as in the conventional light-emitting diode. Thus, the process for fabricating the light-emitting diode 10 is simplified, whereby the diode 10 is available at a relatively low cost.

In the instant embodiment, the light-reflecting/photoluminescent layer 14 is provided on the side of the active layer 18 remote from the light-emitting surface 28. Therefore, the component of the light generated by the active layer 18 and directed toward the substrate 12 is either reflected by the layer 14 so as to improve the intensity of the 780nm-wavelength light emitted from the light-emitting surface 28, or converted by the layer 14 into the 870nm-wavelength light which is also emitted from the light-emitting surface 28. Thus, the component of the light incident upon the layer 14 is fully utilized for the optical output of the diode 10, and the electric consumption by the diode 10 is suitably reduced.

The AlAs/GaAs superlattice 30, 32 of the light-reflecting/photoluminescent layer 14 does not suffer from lattice mismatch with respect to the p-GaAs substrate 12 and the p-Ga$_{0.55}$Al$_{0.45}$As clad layer 16.

While the present invention has been described in the presently preferred embodiment with a certain degree of particularity, for illustrative purpose only, it is to be understood that the invention may be otherwise embodied.

Between the substrate 12 and the light-reflecting/photoluminescent layer 14 of the illustrated embodiment, there may be provided a light-reflecting layer adapted to reflect a portion of the light generated by the photoluminescent layer 14 toward the substrate 12, back toward the light-emitting surface 28.

In the illustrated embodiment, the light-reflecting/photoluminescent layer 14 is provided on the side of the active layer 18 remote from the light-emitting surface 28. However, the layer 14 may be replaced by a light-transmitting photoluminescent layer. It is also possible to provide such a photoluminescent layer between the active layer 18 and the light-emitting surface 28. Alternatively, the light-reflecting photoluminescent layer 14 may be eliminated, and the substrate 12 or contact layer 22 may serve as a photoluminescent layer capable of emitting a light which is different from the light generated by the active layer 18.

In the illustrated embodiment, the light-emitting diode 10 is adapted to emit two kinds of lights having respective wavelengths of 780nm and 870nm at the same time. However, the light-emitting diode of the invention may be constructed so as to generate lights having wavelengths other than 780nm and 870nm, by suitably selecting materials for the active layer and the photoluminescent layer. It is also possible to provide two or more photoluminescent layers for generating at a time at least three kinds of lights having different wavelengths. Where the diode is provided with two or more photoluminescent layers, all these layers may be adapted to absorb the light generated by the active layer, so as to generate respective lights of different wavelengths. Alternatively, one of the two or more photoluminescent layers may absorb the light generated by the active layer and generate a light having a different wavelength, based on which another photoluminescent layer generates a light having a further different wavelength. In essence, the photoluminescent layer of the invention is required to generate at least one light, based on the first light generated by the active layer.

While the diode 10 of the illustrated embodiment is a surface emission type light-emitting diode having a GaAlAs double-heterostructure, other compound semiconductors such as GaAs, GaP, InP, InGaAsP may be utilized to constitute a double-heterostructure, a single-heterostructure or a homostructure. Further, the present invention is applicable to a diode of a type in which light is emitted from an end face of the active layer. In this case, a light having a wavelength different from that of the light generated by the active layer is emitted from an end face of each photoluminescent layer provided at a desired position.

It is to be understood that the present invention may be embodied with various other changes, modifications and improvements, which may occur to those skilled in the art, without departing from the spirit and scope of the invention defined in the following claims.

A light-emitting diode including a substrate and a plurality of semiconductor layers superposed on the substrate, for emitting at a time a plurality of lights having respective different wavelengths and emitted through a light-emitting surface. The above-indicated plurality of semiconductor layers includes an active layer (18) for generating a first light, upon application of an electric current thereto, and at least one photoluminescent layer (14) each for generating a light having a longer wavelength than the first light, based on the first light generated by the active layer.

## Claims

1. A light-emitting diode including a substrate and a plurality of semiconductor layers superposed on said substrate, for emitting at a time a plurality of lights having respective different wavelengths, said plurality of lights being emitted through a light-emitting surface, said light-emitting diode being characterized in that:

   said plurality of semiconductor layers comprises an active layer (18) for generating said first light, upon application of an electric current thereto, and at least one photoluminescent layer (14) each for generating a light having a longer wavelength than said first light, based on said first light generated by said active layer.

2. A light-emitting diode according to claim 1, wherein each of said at least one photoluminescent layer consists of a superlattice (14) consisting of a plurality of semiconductor films (30, 32) which are alternately superposed on each other.

3. A light-emitting diode according to claim 2, wherein said superlattice consists of an AlAs-GaAs superlattice.

4. A light-emitting diode according to claim 3, wherein said superlattice (14) consists of twenty AlAs films (30) and twenty GaAs films (32).

5. A light-emitting diode according to claim 3, wherein said active layer (18) is a GaAlAs layer, and said first light has a wavelength of 780nm, said at least one photoluminescent layer consisting of one photoluminescent layer (14) which generates a second light having a wavelength of 870nm.

6. A light-emitting diode according to any one of claims 1-5, wherein said at least one photoluminescent layer consists of one photoluminescent layer (14) which is provided on the side of said active layer (18) remote from said light-emitting surface (28).

7. A light-emitting diode according to claim 6, wherein said photoluminescent layer further functions as a wave interference type light-reflecting layer for reflecting a component of said first light generated by said active layer toward said light-emitting surface.

8. A light-emitting diode according to any one of claims 1-7, wherein said substrate (12) consists of a GaAs single crystal.

9. A light-emitting diode according to any one of claims 1-8, wherein said at least one photoluminescent layer consists of one photoluminescent layer (14) which is grown on said substrate, said plurality of semiconductor layers further comprising a first $Ga_{0.55}Al_{0.45}As$ clad layer (16) which is grown on said one photoluminescent layer, and on which said active layer (18) is grown, a second $Ga_{0.55}Al_{0.45}As$ clad layer (20) which is grown on said active layer, and a GaAs contact layer (22) which is grown on said second $Ga_{0.55}Al_{0.45}As$ clad layer and which has said light-emitting surface (28), said active layer being a $Ga_{0.87}Al_{0.13}As$ layer.

10. A light-emitting diode according to claim 9, wherein said substrate has a thickness of 350$\mu$m, and said first and second clad layers have a thickness of 2$\mu$m, said active layer and said GaAs contact layer having a thickness of 0.1$\mu$m.

11. A light-emitting diode according to claim 9, further comprising a pair of positive and negative electrodes (24, 26), one of which is disposed on said light-emitting surface of said GaAs contact layer, and the other of which is disposed on said substrate.

12. A light-emitting diode according to claim 11, wherein said negative electrode (24) principally consists of AuGe, Ni and Au, while said positive electrode (26) principally consists of AuZn, Ti and Au.

13. A light-emitting diode according to claim 9, further comprising a light-reflecting layer disposed between said substrate and said photoluminescent layer, for reflecting said light generated by said photoluminescent layer, toward said light-emitting surface.

14. A light-emitting diode according to claim 1, wherein said at least one photoluminescent layer consists of a light-transmitting photoluminescent layer disposed between said active layer and said light-emitting surface.

15. A light-emitting diode according to any one of claims 1-14, wherein said light-emitting surface is a top surface of the diode remote from substrate and parallel to said active layer.

FIG. 1

FIG. 2

# FIG. 3

INTENSITY OF EMITTED LIGHT

WAVELENGTH (nm)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 114 548 (THOMSON)<br><br>* page 3, line 17 - page 7, line 22; figures 1-6 * | 1-6,<br>8-12,15 | H01L33/00 |
| Y | | 13 | |
| Y | DE-A-3 404 875 (LICENTIA-PATENT-VERWALTUNG)<br>* page 3, line 24 - page 4, line 3 *<br>* page 5, line 9 - page 6, line 4; figure 1 * | 13 | |
| X | US-A-4 775 876 (C.D.MOYER)<br>* column 1, line 46 - column 2, line 27; figures 1-2 * | 1,6,8 | |
| A | EP-A-0 184 463 (SHARP)<br>* claims 1-3; figure 1 * | 2-5 | |
| A | PHYSICS TODAY.<br>May 1976, NEW YORK US<br>pages 38 - 47;<br>H.KRESSEL ET AL.: 'Light sources'<br>* figure 4 * | 9-11 | TECHNICAL FIELDS SEARCHED (Int. Cl.5 ) |
| A | PATENT ABSTRACTS OF JAPAN<br>vol. 7, no. 280 (E-216)(1425) 14 December  1983<br>& JP-A-58 159 385 ( TOSHIBA ) 21 September 1983<br>* abstract * | 1,14 | H01L |
| A | PATENT ABSTRACTS OF JAPAN<br>vol. 7, no. 208 (E-198)(1353) 14 September 1983<br>& JP-A-58 103 182 ( NIPPON DENKI ) 20 June 1983<br>* abstract * | 1,14 | |

The present search report has been drawn up for all claims

| Place of search | Date of completion of the search | Examiner |
|---|---|---|
| BERLIN | 24 FEBRUARY 1992 | MUNNIX S. |